Europäisches Patentamt

European Patent Office

Office européen des brevets

(19)

(11) Numéro de publication : **0 165 835**
**B1**

# (12) FASCICULE DE BREVET EUROPÉEN

(45) Date de publication du fascicule du brevet :
**09.11.88**

(51) Int. Cl.⁴ : **H 01 F 40/06, H 01 F 27/36**

(21) Numéro de dépôt : **85400904.0**

(22) Date de dépôt : **09.05.85**

(54) **Capteur de courant à noyau amagnétique.**

(30) Priorité : **21.05.84 FR 8408000**

(43) Date de publication de la demande :
**27.12.85 Bulletin 85/52**

(45) Mention de la délivrance du brevet :
**09.11.88 Bulletin 88/45**

(84) Etats contractants désignés :
**AT BE CH DE GB IT LI NL SE**

(56) Documents cités :
**DE-A- 1 913 553**
**DE-A- 2 054 317**
**DE-B- 1 056 735**
**FR-A-   561 512**
**FR-A-   874 133**
**FR-A- 1 508 358**
**US-A- 3 517 361**
**US-A- 3 925 744**

(73) Titulaire : **MERLIN GERIN**
**Rue Henri Tarze**
**F-38050 Grenoble Cédex (FR)**

(72) Inventeur : **Souchere, Claude**
**Merlin Gerin**
**F-38050 Grenoble Cedex (FR)**

(74) Mandataire : **Kern, Paul et al**
**Merlin Gerin Sce. Brevets 20, rue Henri Tarze**
**F-38050 Grenoble Cédex (FR)**

EP 0 165 835 B1

## Description

L'invention est relative à un capteur de courant comprenant un noyau torique en un matériau amagnétique, un bobinage primaire constitué par un conducteur traversant ledit noyau et un bobinage secondaire constitué par un enroulement bobiné sur le noyau.

Les capteurs amagnétiques du genre mentionné ne sont pas sensibles aux phénomènes de saturation magnétique, mais ils délivrent un signal relativement faible. Ils sont couramment utilisés dans les systèmes électroniques de surveillance ou de protection, notamment en basse tension (DE-A-1913553). Leur utilisation pose des problèmes de parasites, dont le niveau peut atteindre celui du signal, et le document précité décrit un bobinage secondaire à plusieurs couches, agencées pour compenser l'influence des conducteurs adjacents. La fabrication de tels enroulements multicouches est compliquée et lorsque ce capteur est appliqué à des installations à moyenne ou haute tension, on constate que le signal varie avec la tension.

La présente invention a pour but de permettre la réalisation d'un capteur de courant amagnétique, dont le niveau de bruit est faible, notamment dans les installations à moyenne ou haute tension.

Le capteur selon la présente invention est caractérisé en ce qu'il comporte un écran électrostatique en un matériau conducteur amagnétique, interposé entre le conducteur primaire et le noyau amagnétique avec le bobinage secondaire et un écran magnétique entourant extérieurement le noyau avec le bobinage secondaire.

L'écran magnétique extérieur constitue un blindage qui permet de s'affranchir des perturbations externes, notamment de toute induction parasite extérieure. Il a néanmoins été constaté que ce blindage extérieur est insuffisant et que le signal délivré par le capteur varie avec la tension appliquée au capteur. Par l'adjonction d'un écran électrostatique, il est possible d'éliminer cette perturbation du signal délivré par le capteur de courant et d'obtenir un signal de mesure fidèle, même dans les installations à haute tension. L'étude de ce phénomène indique que son origine est due à la capacité existant entre le conducteur primaire et la couche externe du bobinage secondaire, ce qui explique l'efficacité de l'écran électrostatique.

Le document FR-A-874133 décrit un capteur de courant à haute tension à noyau magnétique avec un écran amagnétique interposé entre le noyau et le conducteur primaire. Cet écran évite la formation d'effluves par une meilleure répartition du champ électrique. Le niveau des parasites intrinsèques est négligeable par rapport à la puissance du signal émis par le capteur à noyau magnétique et une éventuelle influence de l'écran de répartition de champ sur ces parasites serait nulle.

Des écrans en tôles entourant partiellement ou totalement le capteur sont connus (DE-B-1056735, FR-A-561512), mais de tels écrans sont inutilisables pour des capteurs à noyau amagnétique.

Il est avantageux de relier l'écran électrostatique à la terre ou à la masse pour éviter tout potentiel électrique dans la zone de mesure.

L'écran magnétique est de préférence une virole cylindrique en un matériau à forte perméabilité magnétique, à l'intérieur de laquelle est logé le noyau torique portant le bobinage secondaire. L'écran électrostatique conducteur présente une très faible perméabilité et peut être en cuivre ou en aluminium ou en tout autre matériau approprié. Différentes structures d'écran sont concevables, notamment une pièce rigide disposée partiellement ou totalement autour du noyau avec son bobinage ou un bandage conducteur enveloppé autour du noyau et de son bobinage ou encore une simple couche conductrice, par exemple une peinture ou un dépôt conducteur.

D'autres avantages et caractéristiques ressortiront plus clairement de la description qui va suivre de deux modes de mise en œuvre de l'invention, donnés à titre d'exemples non limitatifs, et représentés au dessin annexé, dans lequel :

la figure 1 est une vue en élévation d'un capteur selon l'invention,

la figure 2 est une coupe suivant la ligne II-II de la figure 1,

les figures 3 et 4 sont des vues analogues à celles des figures 1 et 2, illustrant une variante de réalisation.

Sur les figures un noyau 10 en un matériau amagnétique en forme de tore est traversé axialement par un conducteur 12 parcouru par le courant à mesurer. Le conducteur 12 appartient à une installation, notamment un tableau ou un appareil moyenne tension ou haute tension et constitue l'enroulement primaire à un seul passage du capteur. Cet enroulement primaire peut comporter plusieurs passages d'une manière bien connue en soi. Sur le noyau torique 10 est enroulé un bobinage secondaire 14 ayant des fils de connexion 16. Le noyau 10 et le bobinage 14 sont disposés coaxialement à l'intérieur d'un écran 18, en forme de virole cylindrique, qui les enveloppe à faible jeu en débordant latéralement de part et d'autre. L'écran 18 est en un matériau à forte perméabilité magnétique du genre ferrosilicium ou mumétal et constitue un blindage extérieur du capteur.

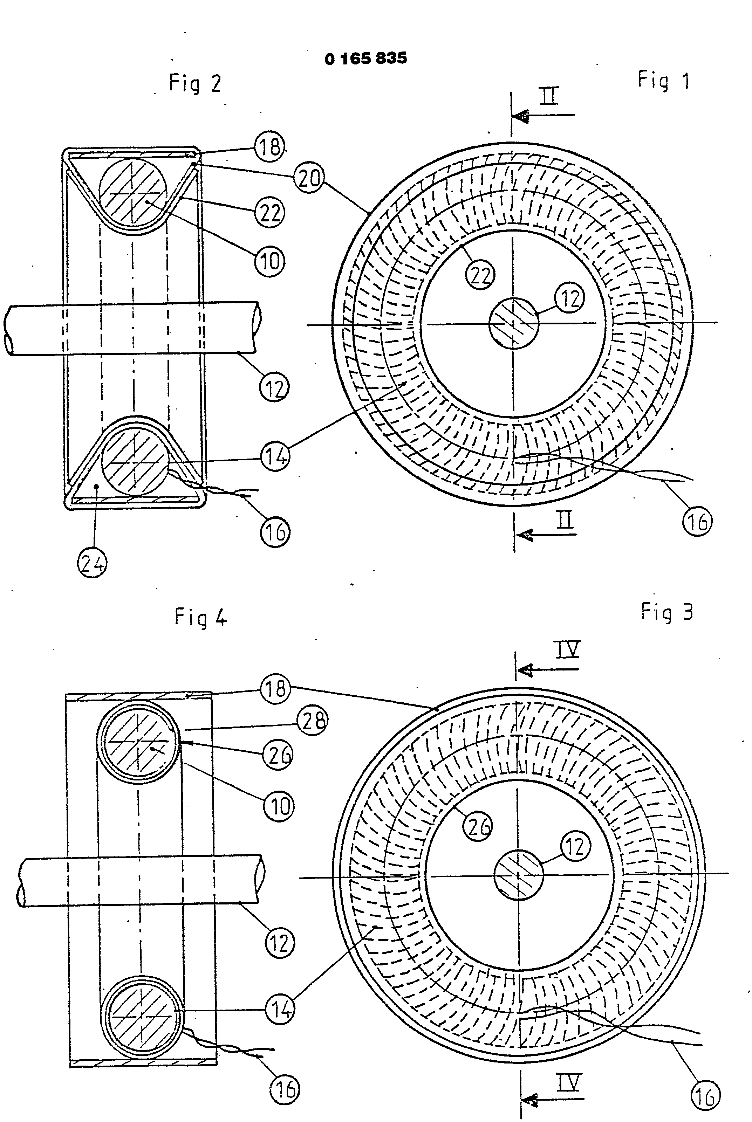

Sur les figures 1 et 2 l'ensemble noyau 10, bobinage 14 et écran 18 est enveloppé d'une gaine isolante 20, par exemple constituée d'une bande enroulée à chevauchement autour de l'ensemble. Un écran intérieur 22 en forme d'anneau présente une gorge externe 24 en V, dans laquelle est logé le noyau 10 avec le bobinage 14. Le profil du fond de la gorge 24 correspond à celui du noyau 10 qui vient se plaquer au fond de la gorge 24. Les flancs en V de la gorge 24 s'étendent jusqu'au voisinage de l'écran extérieur 18, qui obture quasi totalement la gorge 24 avec interposition de la gaine isolante 20, qui épouse le profil de la gorge 24.

Le montage de l'écran intérieur 22 sur le noyau 10 peut être réalisé par déformation ou par assemblage de pièces complémentaires ou de toute autre manière. L'écran intérieur 22 est en un matériau conducteur amagnétique ou à très faible perméabilité, tel que le cuivre ou l'aluminium et il constitue un blindage électrostatique, avantageusement mis à la masse ou à la terre et intercalé entre le conducteur primaire 12 et l'extérieur du bobinage secondaire. Des essais ont montré que ce blindage 22 permet d'obtenir un signal aux bornes 16 du bobinage secondaire 14 quasi indépendant de la tension du courant parcourant le conducteur 12. L'ensemble peut être enrobé dans une matière isolante moulée et il est clair que l'isolation par la gaine 20 peut être réalisée d'une manière différente, notamment par enrobage. La forme torique est la plus usuelle mais l'écran électrostatique selon l'invention est utilisable avec des tores ou anneaux aplatis, ou de forme ou de section différente, notamment rectangulaire.

Les figures 3 et 4 illustrent une variante de réalisation de l'écran électrostatique interne, les mêmes numéros de référence désignant sur ces figures des éléments analogues ou identiques à ceux des figures 1 et 2. L'écran électrostatique est constitué par un anneau ou tore circulaire creux 26, à l'intérieur duquel est logé à faible jeu le noyau 10 portant le bobinage 14 avec interposition d'une gaine isolante 28, elle-même en forme de tore. Dans cette variante l'écran électrostatique 26 entoure totalement le noyau 10 et le bobinage 14 et il s'étend du côté de l'écran magnétique extérieur 18, ce qui ne modifie nullement le fonctionnement du capteur.

## Revendications

1. Capteur de courant comprenant un noyau torique (10) en un matériau amagnétique, un bobinage primaire constitué par un conducteur (12) traversant ledit noyau (10) et un bobinage secondaire (14) constitué par un enroulement bobiné sur le noyau (10), caractérisé en ce qu'il comporte un écran électrostatique (22, 26) en un matériau conducteur amagnétique, interposé entre le conducteur primaire (12) et le noyau amagnétique (10) avec le bobinage secondaire (14), et un écran magnétique (18) entourant extérieurement le noyau (10) avec le bobinage secondaire (14).

2. Capteur de courant selon la revendication 1, caractérisé en ce que l'écran (18) magnétique extérieur est constitué par une virole cylindrique entourant coaxialement à faible jeu le noyau torique (10) avec le bobinage secondaire (14) ladite virole débordant de part et d'autre du noyau.

3. Capteur de courant selon la revendication 1, caractérisé en ce que l'écran magnétique (18) est en un matériau à forte perméabilité magnétique tel que le mumétal ou le ferrosilicium.

4. Capteur de courant selon la revendication 1, 2 ou 3, caractérisé en ce que l'écran (22, 26) amagnétique interne est constitué par un anneau accolé coaxialement au pourtour interne du noyau (10) avec le bobinage secondaire (14).

5. Capteur de courant selon la revendication 4, caractérisé en ce que ledit anneau (22) présente une gorge (24) en V, dans laquelle est logé le noyau (10) avec le bobinage secondaire (14), les flancs de la gorge s'étendent de part et d'autre du noyau (10) jusqu'au voisinage de l'écran extérieur (18), qui obture quasi totalement l'ouverture de la gorge (24).

6. Capteur de courant selon la revendication 4, caractérisé en ce que l'écran (26) amagnétique interne est constitué par un tore creux à l'intérieur duquel est logé le noyau (10) avec le bobinage secondaire (14).

7. Capteur de courant selon l'une quelconque des revendications précédentes, caractérisé en ce que l'écran amagnétique (22, 26) est en cuivre, en aluminium ou à base de cuivre ou d'aluminium.

8. Capteur de courant selon l'une quelconque des revendications précédentes, caractérisé en ce que l'écran amagnétique ((22, 26) est mis à la terre ou à la masse.

9. Capteur de courant selon l'une quelconque des revendications précédentes, caractérisé en ce qu'il comporte une couche isolante (20) insérée entre l'écran amagnétique (22, 26) et le bobinage secondaire (14).

10. Capteur de courant selon l'une quelconque des revendications précédentes, caractérisé en ce que le conducteur primaire (12) est parcouru par un courant moyenne ou haute tension.

## Claims

1. Current sensor comprising a ring core (10) made of a nonmagnetic material, a primary winding constituted by a conductor (12) running through said core (10) and a secondary winding (14) constituted by a turn wound on the core (10), characterized in that it comprises an electrostatic shield (22, 26) made of a non-magnetic conducting material, inserted between the primary conductor (12) and the non-magnetic core (10) with the secondary winding (14), and a magnetic shield (18) enclosing outsides the core (10) with the secondary winding (14).

2. Current sensor according to claim 1, characterized in that the external magnetic shield (18) is constituted by a cylindrical shell coaxially enclosing with little clearance the ring core (10) with the secondary winding (14), said shell extending on both sides of the core.

3. Current sensor according to claim 1, characterized in that the magnetic shield (18) is made of a material with a high magnetic permeability such as mumetal or ferrosilicon.

4. Current sensor according to claim 1, 2 or 3, characterized in that the internal non-magnetic shield (22, 26) is constituted by a ring coaxially embracing the internal circumference of the core (10) with the secondary winding (14).

5. Current sensor according to claim 4, characterized in that said shield (22) has a V-shaped recess (24), in which is housed the core (10) with the secondary winding (14), the walls of the recess extending on both sides of the core (10) in proximity to the external shield (18), which almost totally obturates the opening of the recess (24).

6. Current sensor according to claim 4, characterized in that the internal non-magnetic shield (26) is constituted by a hollow ring inside which is housed the core (10) with the secondary winding (14).

7. Current sensor according to any of the above claims, characterized in that the non-magnetic shield (22, 26) is made of copper or aluminium or is copper or aluminium-based.

8. Current sensor according to any of the above claims, characterized in that the non-magnetic shield (22, 26) is earthed or grounded.

9. Current sensor according to any of the above claims, characterized in that it comprises an insulating layer (20) inserted between the non-magnetic shield (22, 26) and the secondary winding (14).

10. Current sensor according to any of the above claims, characterized in that the primary conductor (12) has a medium or high voltage current flowing through it.

**Patentansprüche**

1. Stromsensor mit einem torischen Kern (10) aus einem unmagnetischen Material, einer von einem den genannten Kern (10) durch querenden Leiter (12) gebildeten Primaerwicklung und einer Sekundaerwicklung (14), die von einer auf den Kern (10) gespulten Wicklung gebildet wird, dadurch gekennzeichnet, dass er einen elektrischen Schirm (22, 26) aus leitfaehigem, unmagnetischen Material aufweist, der zwischen dem Primaerleiter (12) und dem unmagnetischen Kern (10) mit der Sekundaerwicklung (14) eingefuegt ist, und einen magnetischen Schirm (18), der aeusserlich den Kern (10) mit der Sekundaerwicklung (14) umgibt.

2. Stromsensor gemaess Anspruch 1, dadurch gekennzeichnet, dass der aeussere magnetische Schirm (18) von einem zylindrischen Reifen gebildet wird, der mit geringem Spielraum den torischen Kern (10) mit der Sekundaerwicklung (14) umgibt, wobei der genannte Reifen auf beiden Seiten des Kern vorsteht.

3. Stromsensor gemaess Anspruch 1, dadurch gekennzeichnet, dass der magnetische Schirm (18) aus einem Material mit hoher magnetischer Durchlaessigkeit besteht, so wie Mu-Metall oder Siliziumeisen.

4. Stromsensor gemaess Anspruch 1, 2 oder 3, dadurch gekennzeichnet, dass der innere unmagnetische Kern (22, 26) von einem Ring gebildet wird, der koaxial an dem inneren Umfang des Kerns (10) mit der Sekundaerwicklung (14) anliegt.

5. Stromsensor gemaess Anspruch 4, dadurch gekennzeichnet, dass der genannte Ring (22) eine V-foermige Rille (24) aufweist, in welcher der Kern (10) mit der Sekundaerwicklung (14) angeordnet ist, wobei sich die Flanken der Rille auf beiden Seiten des Kerns (10) erstrecken bis in die Naehe des aeusseren Schirms (18), der die Oeffnung der Rille (24) praktisch voellig verschliesst.

6. Stromsensor gemaess Anspruch 4, dadurch gekennzeichnet, dass der innere fxc unmagnetische Schirm (26) von einer hohlen Ringflaeche gebildet wird, in deren Innern der Kern (10) mit der Sekundaerwicklung (14) untergebracht ist.

7. Stromsensor gemaess irgendeinem der vorhergehenden Ansprueche, dadurch gekennzeichnet, dass der unmagnetische Schirm (22, 26) aus Kupfer, aus Aluminium oder vorwiegend aus Kupfer oder Aluminium besteht.

8. Stromsensor gemaess irgendeinem der vorhergehenden Ansprueche, dadurch gekennzeichnet, dass der unmagnetische Schirm (22, 26) geerdet oder an die Masse geleitet wird.

9. Stromsensor gemaess irgendeinem der vorhergehenden Ansprueche, dadurch gekennzeichnet, dass er eine Isolierschicht (20) aufweist, die zwischen dem unmagnetischen Schirm (22, 26) und der Sekundaerwicklung (14) eingefuegt ist.

10. Stromsensor gemaess irgendeinem der vorhergehenden Ansprueche, dadurch gekennzeichnet, dass der Primaerleiter (12) von einem Mittelspannungs- oder Hochspannungsstrom durchflossen wird.

0 165 835